Europäisches Patentamt

European Patent Office

Office européen des brevets

(11) Publication number: **0 242 298**
A2

# (12) EUROPEAN PATENT APPLICATION

(21) Application number: **87400859.2**

(22) Date of filing: **15.04.87**

(51) Int. Cl.⁴: **H 01 L 31/10**
**H 01 L 31/02**

(30) Priority: **15.04.86 JP 86299/86**

(43) Date of publication of application:
**21.10.87 Bulletin 87/43**

(84) Designated Contracting States: **DE FR GB**

(71) Applicant: **FUJITSU LIMITED**
**1015, Kamikodanaka Nakahara-ku**
**Kawasaki-shi Kanagawa 211 (JP)**

(72) Inventor: **Mikawa, Takashi**
**3-1-407, Kamiyoga 2-chome**
**Setagaya-ku Tokyo 158 (JP)**

**Kaneda, Takao**
**1-8-702, Hakusan 5-chome**
**Asao-ku Kawasaki-shi Kanagawa 215 (JP)**

(74) Representative: **Joly, Jean-Jacques et al**
**CABINET BEAU DE LOMENIE 55, rue d'Amsterdam**
**F-75008 Paris (FR)**

(54) Avalanche photo-diode.

(57) The avalanche photo-diode has an avalanche multiplication layer (33) made of a material which can cause a resonant impact ionization, provided between a window layer (34) having a big band gap energy and a light-absorbing layer (32) having a band gap energy smaller than that of the window layer. Field intensity in the light absorbing layer is lowered, thus reducing dark current produced by tunnel effect in the light absorbing layer. A large ionization ratio is obtained during resonant impact ionization allowing a a reduction of the excessive noise factor and of the operating DC voltage applied to the APD, and an increase in operation speed. Excessive noise factor below 3, an operating voltage as low as 12.5 V, and operation at 10 GHZ are achieved.

FIG.3

**Description**

This invention relates to a semiconductor avalanche photo-diode (referred to hereinafter as APD). More particularly, it relates to an APD having improved dark current, noise and high frequency characteristics by achieving uniform avalanche multiplication therein.

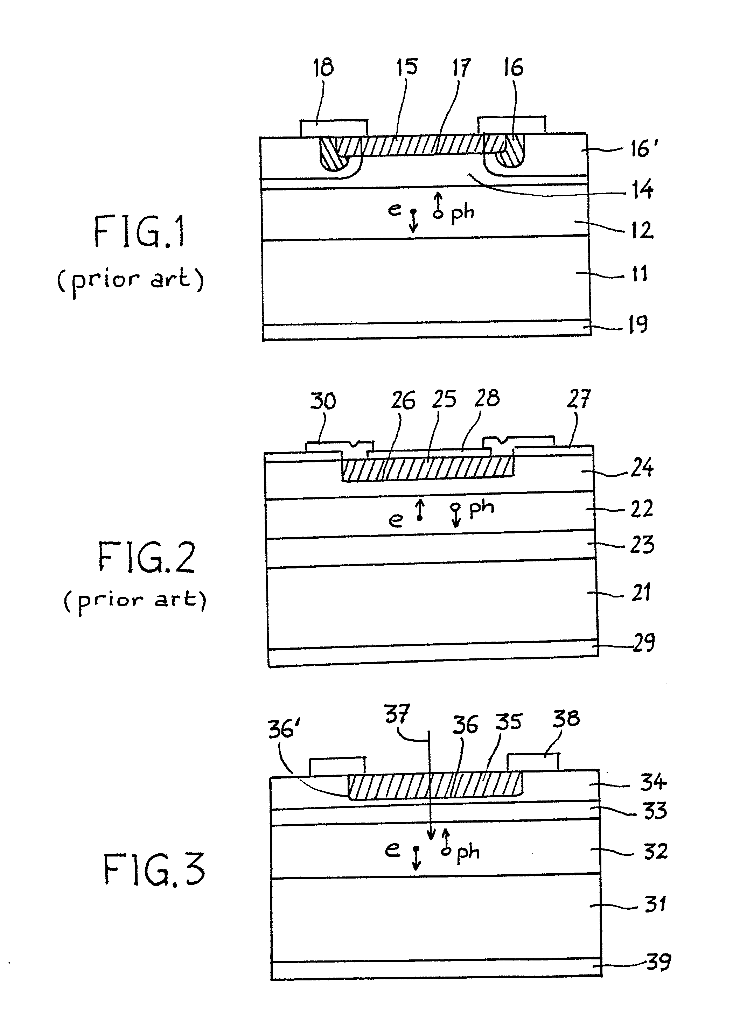

Long-distance and high-capacity optical transmission systems operating at a wave length of 1.0 to 1.7 micron, and using silica optical fibers having a minimum optical transmission loss are increasingly in practical use. As an optical detector for such applications, an APD device composed of InP/GaInAs (Indium-Phosphorus/Galium-Indium-Arsenide) is generally used. Its structure is schematically shown in cross-sectional side view in Fig.1. A DC operating voltage of approximately 100 V is applied between a negative electrode 18 and a positive electrode 19. Numeral 11 denotes an n+-type InP substrate over which an n-type GaInAs light-absorbing layer 12 is formed, in which electrons and positive holes are excited by light injected thereinto. The mark "e" denotes an electron, and the mark "ph" denotes a positive hole both of which are produced by light excitation. The arrow marks indicate directions of their move under the applied operating voltage. Numeral 14 denotes a window layer, sometimes called a multiplication region, made of InP, in which the positive holes from the light-absorbing region 12 are accelerated by the externally applied voltage so that an avalanche multiplication takes place therein. Numeral 16' denotes a guard-ring-burying layer made of n--type InP. Numeral 15 denotes a p+ region doped in the window layer 14, with which a pn junction 17 is formed. The p+ region 15 and the window layer 14 are transparent so that the injected light can reach the light-absorbing layer 12. Numeral 16 denotes a p-type guardring formed in the guardring-burying layer 16' for relaxing excessive concentrations of electric field lines which may cause avalanche breakdown at unexpected low voltage. Electrode 18 is formed over the p-type guardring 16 whereas electrode 19 is formed on the lower face of substrate 11.

In order to reduce the multiplication noise and dark current produced in the device of Fig.1, and APD device employing resonant impact ionization, which was reported by O. Hildebrand et al. in IEEE JQE-17, No.2, page 284, 1981, have been proposed by T.Kaneda, one of the present inventors, as disclosed in JP-A-60-105281, and shown in cross-sectional side view in the enclosed Fig.2, or by P.Pichard et al. as reported in "1.3 micron CdHgTe AVALANCHE PHOTODIODES FOR FIBER OPTIC APPLICATON" in page 479 of 9th European Conference on Optical Communication, 1983.

In Fig.2, numeral 21 denotes a p+-type GaSb (Galium-Antimony) substrate. An avalanche multiplication layer 22, a light absorbing layer 23 and a window layer 24 are successively formed over substrate 21. The window layer 24 is made of p-type $Ga_{0.6}Al_{0.4}Sb$ (Galium-Aluminum whose contents ratio is 0.6 : 0.4, and Antimony). In the window layer 24, an n+ region 25 is provided to form a pn junction 26 with the window layer 24. Numeral 27 denotes a protection film and numeral 28 denotes an anti-reflection layer. The anti-reflection layer 28, the n+ region 25 and the window layer 24 are all treatment for allowing light to be injected into the light-absorbing layer 22.

The light-absorbing layer 22 is made of p-type $Ga_{0.9}Al_{0.1}Sb$. Electrons and positive holes are produced in layer 22 under the excitation by the light injected thereinto. The avalanche multiplication region 23 is made of $Ga_{0.935}Al_{0.065}Sb$. This particular material, $Ga_{0.935}Al_{0.065}Sb$, can cause avalanche multiplication by resonant impact ionization by positive holes from the light absorbing layer 22 when an electric field of approximately $4 \times 10^4$ V/cm is applied thereto, which requires approximately 20 V between electrode 30 formed over the n+region 25 as a positive terminal and electrode 29 formed on the lower surface of substrate 21 as a negative terminal.

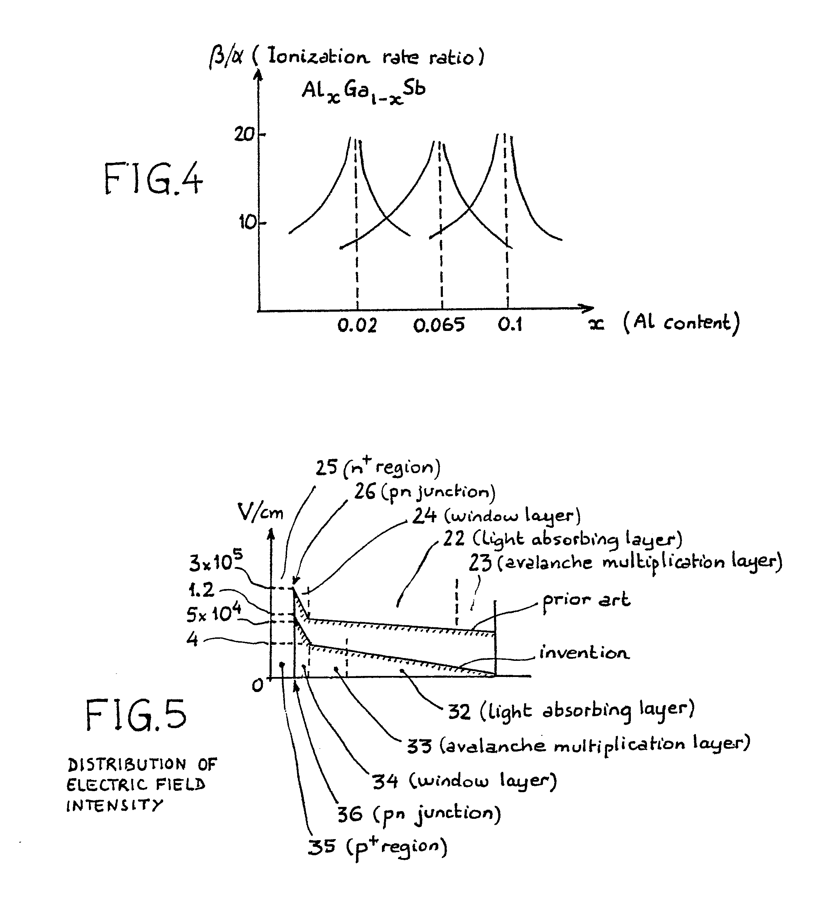

In the APD configuration of Fig.2, the avalanche multiplication layer 23 must be located on the opposite side of the light absorbing layer 22 from the pn junction 26; in other words, the layers are arranged in the following order: pn junction 26, window layer 24, light absorbing layer 22 and avalanche multiplication layer 23. Accordingly, when the operating reverse voltage is applied between the electrodes 29 and 30 in order to obtain the necessary electric field intensity, i.e. $4 \times 10^4$ V/cm, in the avalanche multiplication layer 23, the distribution of the electric field intensity is as shown by the curve "prior art" in Fig.5. Consequently, the applied voltage corresponding to the required field intensity must be larger than a certain value, and an electric field greater than that in the avalanche multiplication layer 23 must be applied also to the light absorbing layer 22. As undesirable results, a dark current by tunnel effect subsists, and it is difficult to dope n-type impurities into the p-type GaAlSb window layer as a mass production process.

It is the object of the invention to provide an APD having a decreased dark current and improved noise and high frequency characteristics, but requiring no difficult technique for its fabrication.

According to the present invention, an avalanche photo-diode is provided which comprises: a semiconductor substrate of a first conductivity type; a light-absorbing layer of a semiconductor material of said first conductivity type formed on said substrate, said light absorbing layer producing carriers in response to the intensity of light received; an avalanche multiplication layer composed of a semiconductor material which causes carrier multiplication therein by resonant impact ionization, the avalanche multiplication layer being of said first conductivity type, being formed on the light-absorbing layer and having a first band gap energy; a window layer of a semiconductor material of said first conductivity type formed on said avalanche multiplication layer, and having a second band gap energy which is bigger than said first band gap energy; a doped impurity region of semiconductor material of a second conductivity type opposite said first conductivity type, which is formed in a side of the window layer opposite the avalanche multiplication layer; a first electrode formed so as to contact the impurity region; and a second electrode formed so as to contact the semiconductor substrate.

Because of the resonant impact ionization in the avalanche multiplication layer, an ionization rate ratio ($\beta/\alpha$) as high as 20 or more is obtained therein, resulting in low noise as well as fast APD operation.

Further, in the APD according to the present invention, the window layer is made of a material whose band gap energy is bigger than that of the multiplication layer. Because of the big band gap energy of the material composing the pn junction where the electric field intensity is maximum, dark current by tunnel effect is reduced. Furthermore, due to the increased avalanche breakdown voltage of the pn junction, the breakdown voltage of the APD is increased. The increased breakdown voltage at the pn junction further contributes to the increase of the breakdown voltage of a portion where the electric field lines are concentrated, such as the peripheral portion of the pn junction, as well as any portion of the pn junction having a lattice defect, resulting in a further increase of the breakdown voltage of the APD.

Still further, due to the configuration of the APD according to the pn junction, the window layer, the avalanche multiplication layer, and the light absorbing layer, the electric field intensity in the light absorbing layer is lowered, resulting in a reduction of the dark current caused by the tunnel effect. This configuration also contributes to a lowering of the applied voltage which induces the necessary field intensity in the multiplication layer, because there is no light-absorbing layer between the multiplication layer and the pn junction.

In addition, owing to the resonant impact ionization itself taking place at a low voltage, as well as owing to the configuration including the above-mentioned window layer having a big band gap energy, the applied bias voltage can be reduced, resulting in allowing a voltage margin for the operation voltage of the APD.

The above-mentioned features and advantages of the present invention, together with other objects and advantages, will become more readily apparent from the following description made with reference to the accompanying drawings wherein:

Fig.1 is a cross-sectional side view showing the structure of a prior art APD,

Fig.2 is a cross-sectional side view showing the structure of a prior art APD employing resonant impact ionization,

Fig.3 is a cross-sectional side view schematically illustrating an APD according to the present invention,

Fig.4 shows the effect of aluminum content on ionization rate ratio,

Fig.5 shows a distribution of the electric field in an APD according to the present invention and in the prior art ADP of Fig.2,

Fig.6 shows relations between avalanche breakdown voltage and carrier density in avalanche multiplication materials, and

Fig.7 shows the relation between the excessive noise factor and the carrier density in the avalanche multiplication layer.

Before describing a preferred embodiment of the APD according to the present invention, the mechanism of the resonant impact ionization shall be briefly, explained hereinafter. The resonant impact ionization is a phenomenum in which the spin orbit splitting $\Delta$ of the valence band becomes equal (thus called resonant) to the band gap energy $E_g$ between the conduction band and the valence band; when a great value of ionization rate ratio $\beta / \alpha$, where $\beta$ indicates ionization factor of the positive hole therein, and $\alpha$ indicates the ionization factor of the electron therein, is obtained even at a voltage lower than in the case of conventional avalanche breakdown without resonant impact ionization.

This phenomenum can cause an avalanche breakdown in a particular semiconductor material, such as a compound of Aluminum-Galium-Antimony ($Al_xGa_{1-x}Sb$), the aluminum content x being for example equal to 0.064, when an electric field, such as approximately $4 \times 10^4$ V/cm, is applied thereto. Then, the value of the ionization rate ratio $\beta / \alpha$ can be as high as more than 20. As is well known, the greater the value of the ionization ratio, the more the fluctuation noise produced in the APD is reduced, allowing faster operation of the APD. As shown in Fig.4, the value of the ionization rate ratio $\beta / \alpha$ changes depending on the value x, wherein x indicates the aluminum content in $Al_x Ga_{1-x}Sb$. The location of the peak value changes as shown in the figure depending on parameters of the materials. In the present invention, a value between 0.02 to 0.1 is reasonable for x. The resonant impact ionization can take place also in InAs (Indium-Arsenide), in $Cd_xHg_{1-x}Te$ (Cadmium-Mercury-Tellurium) where the cadmium content is approximately 0.73, and in other materials.

An embodiment of the APD according to the present invention will now be described in detail with reference to Fig.3. Numeral 31 denotes a substrate made of n+-type GaSb having an impurity concentration, for example, of between approximately $10^{17}$ and $10^{18}$cm$^{-3}$. On the substrate 31, a light-absorbing layer 32, approximately 2 to 4 microns thick, made of n-type GaSb having an impurity concentration, for example, of approximately $1 \times 10^{15}$cm$^{-3}$ and having a band gap which meets the wave length of injected light 37 to be detected, is formed by a known method, such as LPE (liquid phase epitaxy). On the light-absorbing layer 32, an avalanche multiplication layer 33 composed of n-type $Al_{0.065}Ga_{0.935}Sb$, approximately 0.5 to 4 microns thick, having an impurity concentration of, for example approximately $1 \times 10^{15}$cm$^{-3}$, is formed also by a known method, such as LPE. The band gap energy of the light absorbing layer 32 is preferably smaller than that of the avalanche multiplication layer 33. On the avalanche multiplication layer 33, a window layer 34, approximately 2 microns thick, made of n-type $Al_xGa_{1-x}Sb$ where x is, for example 0.28, having an impurity concentration of, for example approximately $1 \times 10^{16}cm^{-3}$ and having a bigger band gap energy than the avalanche multiplication layer 33, is formed still by a known technique, such as LPE. The value x of the window layer 34 is chosen more than 0.2, for example, so as to have a bigger band gap energy than that of the avalanche multiplication layer 33. At a central surface of the window layer 34, a p+ region 35 having an impurity concentration of, for example approximately $1 \times 10^{18}cm^{-3}$ at the surface is formed, approximately 1 to 1.5 micron deep, by diffusion of Zn (Zinc) or by ion implantation of Be (Beryllium) into the window layer 34 so that a pn junction 36 is formed with the window layer 34 and the p+ region 35. The fabrication of the p-type region on the n-type layer is easy. For supplying an operating reverse voltage to the APD, an electrode 38, on which the negative side of the voltage is applied, is formed, in a ring shape for example, on the surface edge of the p+ region 35. The electrode 38 is made of Au/Zn/Au (Gold/Zinc/Gold) for example. As a returning terminal of the supplied voltage, an electrode 39 is formed on the bottom surface of the substrate 31, for example with AuGe/Au (Gold-Germanium/Gold).

The light 37 to be detected is injected into the light-absorbing layer 32 through the p+ region 35, the window layer 34 and the avalanche multiplication layer 33, the region 35 and layers 34, 33 being transparent for the injection light 37 because of their wider band gap energy. Electrons "e" and positive holes "ph" are produced in the light-absorbing layer 32 by the excitation of the injected light 37. The produced positive holes "ph" in the light-absorbing layer 32 are accelerated by the applied voltage into the avalanche multiplication layer 33 and window layer 34, both of which are made of semiconductor materials capable of causing avalanche breakdown.

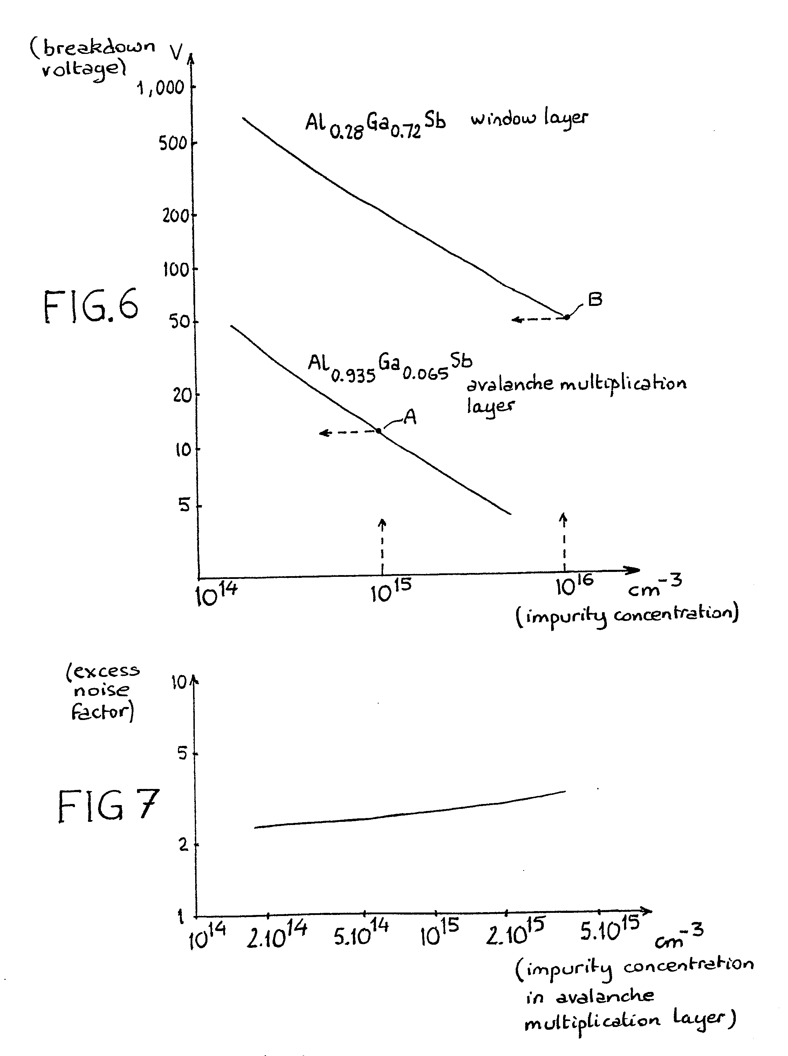

Avalanche breakdown voltages of the n-type $Al_{0.28}Ga_{0.72}Sb$ material used for the window layer 34 and of the n-type $Al_{0.065}Ga_{0.935}Sb$ material used for the multiplication layer 33 are shown in Fig.6 depending on the impurity concentration. As can be observed, the pn junction formed in the window layer having a bigger band gap energy, such as the n-type $Al_{0.28}Ga_{0.72}Sb$, can increase the avalanche breakdown voltage to a value higher than that formed by resonant impact ionization in an avalanche multiplication layer having a smaller band gap energy, such as the n-type $Al_{0.065}Ga_{0.935}Sb$, thus resulting in a lower tunnel current. Furthermore, both the resonant impact ionization taking place at a low voltage and the above-mentioned band gap energy difference contribute to prevent unexpected local avalanche breakdown.

In the APD of Fig.3, when the avalanche multiplication layer 33 has an impurity concentration of $10^{15}cm^{-3}$ and the window layer 34 has an impurity concentration of $10^{16}cm^{-3}$, as indicated respectively by the marks A and B in Fig.7, the avalanche breakdown voltage of the avalanche multiplication layer 33 is approximately 12 V, shown by the mark A, which is much less than the avalanche breakdown voltage of the window layer 34, which is approximately 50V as shown by the mark B.

In Fig.5, distributions of electric field intensity in the APD corresponding to the present invention is compared with that of the prior art APD. Because the avalanche multiplication layer 33 is located between the window layer 34 and the light absorbing layer 32, the electric field intensity applied to the light absorbing layer 32 having a small band gap energy becomes small; thus the dark current is reduced. Further, in Fig. 5, it is observed that the critical electric field intensity for the avalanche breakdown by resonant impact ionization, i.e. $4 \times 10^4$ V/cm, is achieved at the avalanche multiplication layer 33, while the electric field intensity at the pn junction 36 in the window layer 34 is $1.2 \times 10^5$ V/cm which is lower than its avalanche breakdown condition. Thus, because the applied operating voltage of 12.5 V shows an ample margin for the avalanche breakdown of the window layer 34, the avalanche breakdown in the avalanche multiplication layer 33 is not affected by an undesirable local electric field at the pn junction, caused by an irregularity, such as a lattice defect or a sharp peripheral edge, in the window layer 34. Therefore, in the avalanche multiplication layer, the avalanche multiplication can always be initiated uniformly, not being affected by the electric field at the pn junction where the electric field is maximum. The multiplied great amount of positive holes becomes conductive carriers passing through the window layer 34 and the pn junction 36. A this avalanche multiplication, the multiplication factor M easily reaches the value of 10 to 20 which is generally adopted and satisfactory in optical communication systems, and a value of 10 to 20 of the ionization rate $\beta / \alpha$ is easily achieved as well, resulting in a considerable reduction in the excessive noise factor and in an increase of the operation speed.

Fig.7 shows the relation of the excessive noise factor F to the amount of the impurity concentration, when the n-type GaSb light-absorbing layer 32 receives light having a wave length of 1.55 micron, the positive holes produced therein being injected into the $Al_{0.065}Ga_{0.935}Sb$ avalanche multiplication layer 33 and causing an avalanche multiplication whose multiplication factor is 10. As seen in Fig.7, the excessive noise factor F, though varying with the value of the impurity concentration, remains approximately lower than 3. This value 3 is considerably lower than the value approximately equal to 5 achieved with the prior art APD using InP/GaInAs as shown in Fig.1.

As for the operation speed, owing to the increased amount of the ionization, the high frequency response, namely the cut off frequency, is increased from approximately 3 GHZ, with the prior art APD of Fig.1, up to approximately 10 GHZ with the APD according to the present invention. Furthermore, the reduction of the field internally at the pn junction where the field intensity becomes maximum, the big band gap energy of the window layer and the reduction of the field intensity in the light absorbing layer contribute to achieve further reduction of the dark current. Another advantage of the invention lies in that the applied operating voltage is considerably reduced from approximately 100 V in the case of prior art APD of Fig.1, or from approximately 20 V in the case of the prior art APD of Fig.2, down to approximately 12.5 V. Also, the fabrication of the APD of Fig.3 does not raise any difficult problems.

Although no anti-reflection layer and protection layer are referred to in the above description of an embodiment of the APD according to the invention, it is apparent that they can be provided on the window layer as in the APD in Fig.2.

Also, although only one type of material causing resonant impact ionization is referred to in the above description, it is apparent that other materials capable of causing resonant impact ionization can be used in the APD according to the present invention.

## Claims

1. A semiconductor avalanche photo-diode, comprising:

a semiconductor substrate (31) of a first conductivity type;

a light-absorbing layer (32) of a semiconductor material of said first conductivity type formed on the substrate, said light absorbing layer producing carriers in response to the intensity of light received;

an avalanche multiplication layer (33) composed of a semiconductor material which causes carrier multiplication therein by resonant impact ionization, the avalanche multiplication layer being of said first conductivity type, being formed on the light-absorbing layer (32), and having a first band gap energy;

a window layer (34) of a semiconductor material of said first conductivity type formed on the avalanche multiplication layer (33), and having a second band gap energy which is bigger than said first band gap energy;

a doped impurity region (35) of semiconductor material of a second conductivity type opposite said first conductivity type, which is formed in a side of the window layer (34) opposite the avalanche multiplication layer (33);

a first electrode (38) formed so as to contact the impurity region (35); and

a second electrode (39) formed so as to contact the semiconductor substrate (31).

2. A photo-diode according to claim 1, wherein the light-absorbing layer (32) has a third band gap energy which is smaller than said first band gap energy.

3. A photo-diode according to any one of claims 1 and 2, wherein semiconductor material of the avalanche multiplication layer (33) is $Al_xGa_{1-x}Sb$, where the aluminum content x is 0.02 to 0.1.

4. A photo-diode according to any one of claims 1 to 3, wherein the semiconductor material of the avalanche multiplication layer (33) is chosen from the group consisting of InAs and $Cd_xHg_{1-x}Te$, where the cadmium content x is approximately 0.73.

5. A photo-diode according to claim 3, wherein the semiconductor material of the window layer (34) is $Al_xGa_{1-x}Sb$, where the aluminum content x is more than 0.2.

6. A photo-diode according to claim 3, wherein the semiconductor material of the light-absorbing layer (32) is GaSb.

7. A semiconductor photo-diode, comprising:

a semiconductor substrate (31) formed of an n-type GaSb;

a light-absorbing layer (32) composed of an n-type GaSb and formed on the substrate (31);

an avalanche multiplication layer (33) composed on an n-type $Al_xGa_{1-x}Sb$ semiconductor, where the aluminum content x is 0.02 to 0.1, and formed on the light absorbing layer (32);

a window layer (34) composed of an n-type semiconductor having a band gap energy which is bigger than the band gap energy of the light absorbing layer (32), and formed on the avalanche multiplication layer (33); and

a p-type region (35) doped in a side in the window layer (34) opposite the avalanche multiplication layer (33), said p-type region and window region forming a pn junction (36) in the window layer (34).

0242298

**FIG.1**
(prior art)

**FIG.2**
(prior art)

**FIG.3**

0242298

$\beta / \alpha$ ( Ionization rate ratio )

$Al_x Ga_{1-x} Sb$

FIG.4

20

10

0.02  0.065  0.1  $x$  (Al content)

25 ($n^+$ region)
26 (pn junction)
24 (window layer)
22 (light absorbing layer)
23 (avalanche multiplication layer)

V/cm

$3 \times 10^5$
1.2
$5 \times 10^4$
4

prior art

invention

0

32 (light absorbing layer)

33 (avalanche multiplication layer)

34 (window layer)

36 (pn junction)

35 ($p^+$ region)

FIG.5

DISTRIBUTION OF
ELECTRIC FIELD
INTENSITY

0242298

FIG.6

(breakdown voltage) V

$Al_{0.28}Ga_{0.72}Sb$ window layer

$Al_{0.935}Ga_{0.065}Sb$ avalanche multiplication layer

B

A

$cm^{-3}$

(impurity concentration)

FIG 7

(excess noise factor)

$cm^{-3}$

(impurity concentration in avalanche multiplication layer)